(19) Europäisches Patentamt
European Patent Office
Office européen des brevets

(11) **EP 3 435 106 B1**

(12) **EUROPEAN PATENT SPECIFICATION**

(45) Date of publication and mention
of the grant of the patent:
**04.05.2022  Bulletin 2022/18**

(21) Application number: **17770473.1**

(22) Date of filing: **23.01.2017**

(51) International Patent Classification (IPC):
*G01R 35/00* ^(2006.01)   *G01R 15/12* ^(2006.01)
*G01R 19/25* ^(2006.01)   *G01R 19/257* ^(2006.01)
*G01R 19/14* ^(2006.01)

(52) Cooperative Patent Classification (CPC):
**G01R 35/005**

(86) International application number:
**PCT/KR2017/000747**

(87) International publication number:
**WO 2017/164502 (28.09.2017 Gazette 2017/39)**

(54) **DIRECT CURRENT VOLTAGE FUNCTION CALIBRATION DEVICE AND METHOD**

VORRICHTUNG UND VERFAHREN FÜR GLEICHSPANNUNGSFUNKTIONSKALIBRIERUNG

DISPOSITIF ET PROCÉDÉ D'ÉTALONNAGE DE FONCTION DE TENSION CONTINUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.03.2016  KR 20160035448**

(43) Date of publication of application:
**30.01.2019  Bulletin 2019/05**

(73) Proprietor: **Korea Research Institute Of Standards
And Science
Daejeon 34113 (KR)**

(72) Inventors:
• **JUNG, Jae Kap
Daejeon 34189 (KR)**
• **KIM, Kyu Tae
Daejeon 34145 (KR)**

(74) Representative: **Kuhnen & Wacker
Patent- und Rechtsanwaltsbüro PartG mbB
Prinz-Ludwig-Straße 40A
85354 Freising (DE)**

(56) References cited:
JP-A- H03 200 085       JP-A- H04 151 566
JP-A- S62 149 224       KR-A- 20110 010 655
KR-A- 20110 098 036     US-A1- 2015 134 287

• **MARTIN SIRA ET AL: "Comparison of the
Reference Step Method with a MI 8000/8001
potentiometer", PRECISION
ELECTROMAGNETIC MEASUREMENTS (CPEM),
2012 CONFERENCE ON, IEEE, 1 July 2012
(2012-07-01), pages 540-541, XP032211166, DOI:
10.1109/CPEM.2012.6251042 ISBN:
978-1-4673-0439-9**
• **CRISTINA CASSIAGO ET AL: "Application of
DMM Linearity to dc Volt Traceability",
PRECISION ELECTROMAGNETIC
MEASUREMENTS DIGEST, 2004 CONFERENCE
ON, IEEE, PI, 1 June 2004 (2004-06-01), pages
176-177, XP031044687, ISBN: 978-0-7803-8493-4**

# Description

## TECHNICAL FIELD

The present disclosure relates to a measurement device, and more particularly, to a DC voltage function calibration device and method of a multifunction meter calibrator.

## BACKGROUND ART

In "Comparison of the Reference Step Method with a MI 8000/8001 Potentiometer" by Martin Sira et al. (PRECISION ELECTROMAGNETIC MEASUREMENTS 2012 CONFERENCE ON, IEEE, 1 July 2012, pages 540-541, ISBN: 978-1-4673-0439-9) it is summarized a comparison between two methods of building the voltage scale. The first one is the Reference Step Method developed at the Measurements Standards Laboratory of New Zealand. The second one is based on a binary potentiometer represented by the MI 8000/8001 instrument. Both methods were used to calibrate voltage ratios of a Fluke 5720A calibrator.

Multifunction meters and meter calibrators are widely used measuring instruments in future high-tech industries such as smart communications electronics, electric vehicles, and medical diagnostics. Multifunction meters and meter calibrators, for example, are multifunction instruments for measuring DC voltage up to 1 kilovolts (kV), AC voltage of maximum frequency 1 megahertz (Mhz), DC current up to 1 ampere (A), AC current of maximum frequency 10Mhz (megahertz), and resistance up to 1 Gigaohm (G$\Omega$).

As instruments for calibrating multifunction meters, multifunction meter calibrators may be devices that may calibrate voltage, current, and resistance values within the above-mentioned range for each of the five measurement functions of DC voltage, AC voltage, DC current, AC current, and resistance of the multifunction meter, and may have higher stability than multifunction meters. Conventionally, calibration operation should be done by direct comparison of DC voltage, AC voltage, DC current, AC current, and resistance with the higher national standard using a multifunction meter calibrator.

However, the multifunction meter calibrator must be calibrated at various points (measured DC voltage, AC voltage, DC current, AC current, and resistance) for calibration depending on the function. When calibrating at various points about the DC voltage calibrated to this multifunction meter calibrator (or multifunction meter), as the number of points for calibration (DC voltages) increases, more time and more cost are required.

## DISCLOSURE OF THE INVENTION

## TECHNICAL PROBLEM

The present disclosure is to provide a DC voltage function calibration device and method for a multifunction meter and meter calibrator that may save time and money for calibration of various points on the DC voltage.

The present disclosure is also to provide a DC voltage function calibration device and method for calibrating a wide range of points for the DC voltage of a multifunction meter calibrator.

## TECHNICAL SOLUTION

According to the inventive concept, a DC voltage function calibration device includes: a first meter calibrator configured to be calibrated to a reference value for a reference point and having a first plus terminal and a first minus terminal; a second meter calibrator configured to be calibrated to the reference value for the reference point and having a second plus terminal and a second minus terminal connected to the first minus terminal; a digital multi meter having a third plus terminal connected to the first plus terminal and a third minus terminal connected to the second plus terminal; and a DC voltage calibration circuit configured to control the calibration of a DC voltage for other points through up-converting or down-converting a voltage value based on the reference value set in the first meter calibrator and the second meter calibrator, wherein the DC voltage calibration circuit is configured to calibrate an extension point of the digital multi meter using the combined voltage of the first meter calibrator and the second meter calibrator as a reference of the extension point.

In an embodiment, when the DC voltage calibration circuit is calibrated with a reference value as a reference value through a higher standard device for one of the first meter calibrator and the second meter calibrator, the first plus terminal may be connected to the second minus terminal and the second minus terminal may be connected to the first plus terminal to calibrate a voltage of a minus polarity to another meter calibrator.

In an embodiment, the DC voltage calibration circuit may upward-extend the plus polarity point of the third plus terminal and the minus polarity point of the third minus terminal of the digital multi meter through calibration with a combination voltage as a reference of an extension point with respect to a voltage calibrated to the first meter calibrator and the second meter calibrator.

In an embodiment, the DC voltage calibration circuit may calibrate points corresponding to $2^n$ times or $2^{n+1}$ times with respect to the reference value through n-times iterations of an operation according to an upward extension.

In an embodiment, the DC voltage calibration circuit may determine as a virtual reference point a low point corresponding to dividing a minimum point by an integer multiple among the points calibrated to the first meter calibrator and the second meter calibrator, compare the value obtained through the upward extension with the reference value of the minimum point to obtain a state deviation, and calibrate a virtual reference value assigned to the virtual reference point by the state deviation to calibrate the virtual reference point.

In an embodiment, the DC voltage calibration circuit may measure the combination voltage of the first meter calibrator and the second meter calibrator using the digital multi meter, and downward-extend a point corresponding to half the minimum point through calibration after measuring a difference voltage between the first meter calibrator and the second meter calibrator, through a calculation of the output value of the first meter calibrator and the second meter calibrator from the combination voltage and the difference voltage.

In an embodiment, the DC voltage calibration circuit may calibrate points corresponding to $1/2^n$ times with respect to the reference value through n-times iterations of an operation according to the downward expansion.

According to the inventive concept, a DC voltage function calibration method includes: calibrating a reference point as a reference value through a higher standard device for one of a first meter calibrator and a second meter calibrator; connecting a first plus terminal of a first meter calibrator to a second minus terminal of the second meter calibrator and connecting a second plus terminal of the second meter calibrator to a first minus terminal of the first meter calibrator to calibrate a voltage of a minus polarity to another meter calibrator; connecting the first plus terminal to a third plus terminal of a digital multi meter, connecting the second plus terminal to a third minus terminal of the digital multi meter, and connecting the first minus terminal to the second minus terminal; calibrating a plus polarity point and a minus polarity point of a digital multi meter based on a combination point as a reference of an extension point with respect to a voltage calibrated to the first meter calibrator and the second meter calibrator; and calibrating a DC voltage for other points through up-converting or down-converting a voltage value based on the reference value set in the first meter calibrator and the second meter calibrator, wherein an extension point of the digital multi meter is calibrated using the combined voltage of the first meter calibrator and the second meter calibrator as a reference of the extension point.

In an embodiment, the controlling to calibrate the DC voltage for the other points through the up-converting may include upward-extending the plus polarity point of the third plus terminal and the minus polarity point of the third minus terminal of the digital multi meter based on a combination voltage as an extension point through an iteration of a calibration operation with respect to the voltage calibrated to the first meter calibrator and the second meter calibrator.

In an embodiment, the controlling to calibrate the DC voltage for the other points through the up-converting may include: determining as a virtual reference point a low point corresponding to dividing a minimum point by an integer multiple among the points calibrated to the first meter calibrator and the second meter calibrator; comparing the value obtained through the upward extension with the reference value of the minimum point to obtain a state deviation; and calibrating a virtual reference value assigned to the virtual reference point by the state deviation to calibrate the virtual reference point.

In an embodiment, the controlling to calibrate the DC voltage for the other points through the down-converting may include: measuring the combination voltage of the first meter calibrator and the second meter calibrator using the digital multi meter; measuring a difference voltage between the first meter calibrator and the second meter calibrator; and downward-extending a point corresponding to half the minimum point through calibration through a calculation of the output value of the first meter calibrator and the second meter calibrator from the combination voltage and the difference voltage.

## ADVANTAGEOUS EFFECTS

In relation to the DC voltage function calibration method of the inventive concept, when calibration is performed based on one reference point according to the function, since a wide range of points may be calibrated to meet standards, this saves time and money for DC voltage calibration.

## BRIEF DESCRIPTION OF THE DRAWINGS

FIG. 1 is a diagram illustrating a structure of a DC voltage function calibration device of a multifunction meter calibrator according to an inventive concept.
FIG. 2 is a flowchart illustrating an exemplary upward calibration operation of a DC voltage in a DC voltage calibration circuit according to an inventive concept.
FIG. 3 is a flowchart illustrating an exemplary downward calibration operation of a DC voltage in a DC voltage calibration circuit according to an inventive concept.

## BEST MODE FOR CARRYING OUT THE INVENTION

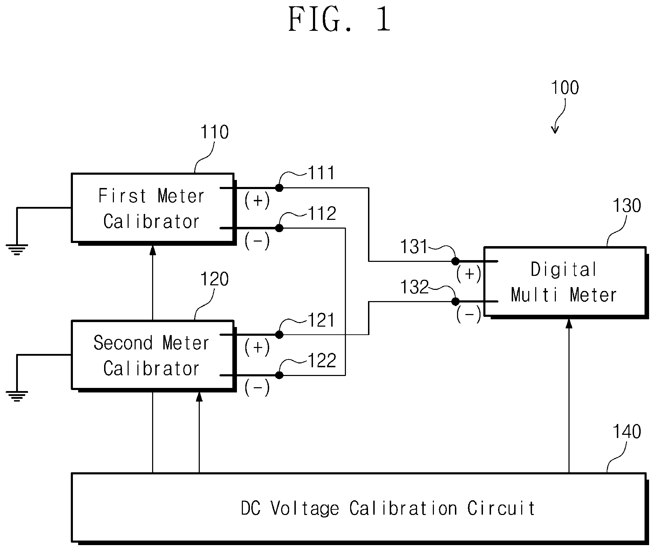

FIG. 1 shows the best mode for the implementation of the inventive concept.

## MODE FOR CARRYING OUT THE INVENTION

Hereinafter, preferred embodiments of the inventive concept will be described in more detail with reference to the accompanying drawings. In the description below, it should be noted that only parts necessary for understanding operations according to the inventive concept are described and descriptions of other parts are omitted not to obscure the scope of the inventive concept.

The inventive concept provides a DC voltage function calibration device and method for calibrating the DC voltage of a multifunction meter and a multifunction meter calibrator. In the following description, for convenience of explanation, a meter calibrator (i.e., a multifunction meter calibrator) will be described and when using a multifunction meter instead of a multifunction meter calibrator, the DC voltage of the multifunction meter may be calibrated.

FIG. 1 is a diagram illustrating a structure of a DC voltage function calibration device of a multifunction meter calibrator according to an inventive concept.

Referring to FIG. 1, a DC voltage function calibration device 100 includes first and second meter calibrators 110 and 120, a digital multi meter 130, and a DC voltage calibration circuit 140.

The first meter calibrator 110 includes a first plus (+) terminal 111 and a first minus (-) terminal 112.

The second meter calibrator 120 includes a second plug terminal 121 and a second minus terminal 122. Here, the first minus terminal 112 of the first meter calibrator 110 and the second minus terminal 122 of the second meter calibrator 120 are connected to each other.

The digital multi meter 130 includes a third plus terminal 131 and a third minus terminal 132. At this time, the third plus terminal 131 is connected to the first plus terminal 111 of the first meter calibrator 110 and the third minus terminal 132 is connected to the second plus terminal 121 of the second meter calibrator 120. The digital multi meter 130 may be a high resolution digital multi meter.

The DC voltage calibration circuit 140 is connected to the first and second meter calibrators 110 and 120 and the digital multi meter 130. Through this, the DC voltage calibration circuit 140 controls a point calibration to a DV voltage value inputted through the plus terminals 111, 121, and 131 and the minus terminals 112, 122, and 132, and an output operation of the DC voltage using the calibrated point, through operation control of the first and second meter calibrators 110 and 120 and the digital multi meter 130.

Moreover, the first and second meter calibrators 110, 120 or the digital multi meter 130 is a device to measure a wide range of DC voltage, and the measurement range of DC voltage is divided into multiple decimal intervals, such as -100mV to 100mV, -1V to 1V, -10V to 10V, -100V to 100V, and -1000V to 1000V (or -220mV to 220mV, -2.2V to 2.2V, -22V to 22V, -220V to 220V, and -1000V to 1000V).

For example, a reference value for the reference point of the first meter calibrator 110 may be given as 10V, for example. However, 10V, which is the reference value for the reference point, is illustratively described, and may be set to various values other than 10V. At this time, the reference value is set based on a higher standard device for example, such as a Zener standard device which is a device provided by a higher standard authority. Thereafter, the reference point of the negative reference value (-10V) may be calibrated through the digital multi meter 130 based on the first meter calibrator 110. The digital multi meter 130 calibrates the reference point with a reference value of 10V through the first meter calibrator 110 and calibrates the second meter calibrator 120 using the digital multi meter 130.

In the following, the calibration for the upper range and the calibration for the lower range will be described for the DC voltage based on the reference point. Hereinafter, for convenience of explanation, it is described that indication values of the first meter calibrator 110 and the digital multi meter 130 have a positive polarity and an indication value of the second meter calibrator 120 has a negative polarity. However, the first meter calibrator 110, the second meter calibrator 120, and the digital multi meter 130 may be configured to have different polarities depending on the implementation.

First, one reference point that meets the standard is calibrated for one of the first and second meter calibrators 110 and 120.

First, the DC voltage calibration circuit 140 sets one of the previously calibrated points to the first meter calibrator 110 and the second meter calibrator 120 to have a positive polarity and a negative polarity, respectively. Thereafter, the DC voltage calibration circuit 140 calibrates the extension point of the digital multi meter 130 using the combined voltage of the first meter calibrator 110 and the second meter calibrator 120 as a reference of the extension point. The DC voltage calibration circuit 140 may calibrate the positive polarity point of the first meter calibrator 110 and the negative polarity point of the second meter calibrator 120 based on the extension point of the digital multi meter 130.

Second, the DC voltage calibration circuit 140 sets one of the previously calibrated points to the first meter calibrator 110 and the second meter calibrator 120 to have a positive polarity and a negative polarity, respectively. The DC voltage calibration circuit 140 measures the combined voltage of the polarities set in the first meter calibrator 110 and the second meter calibrator 120 as the value of the calibrated digital multi meter 130, and after measuring the difference voltage between the first meter calibrator 110 and the second meter calibrator 120, calculates the output of two meter calibrators from the sum voltage and the difference voltage value to calibrate a point that is half the minimum point.

Third, the DC voltage calibration circuit 140 determines a low point corresponding to dividing a minimum point among previously calibrated points by an integer multiple, as a virtual reference point. The DC voltage calibration circuit 140 temporarily assigns the determined reference point as a virtual reference value, and obtains a relative deviation by comparing the value obtained by performing the upward extension calibration process described first from the virtual reference point to the minimum point with the reference value of the minimum point. The DC voltage calibration circuit 140 may calibrate a virtual reference value assigned to the virtual reference point by the relative deviation to calibrate the virtual reference point.

When the DC voltage calibration circuit 140, for example, calibrates the DC voltage value through a higher standard device for one point of the first meter calibrator 110, it may calibrate the multiple points of the first meter calibrator 110 and the multiple points of the second meter calibrator 120 and the digital multi meter 130 through up or down conversion.

Through this, since it is possible to calibrate other points using one point of calibration without having to calibrate all the points using a higher standard device, time and cost for calibrating the DC voltage function of a meter calibrator (or multifunction meter, multifunction meter calibrator) may be saved.

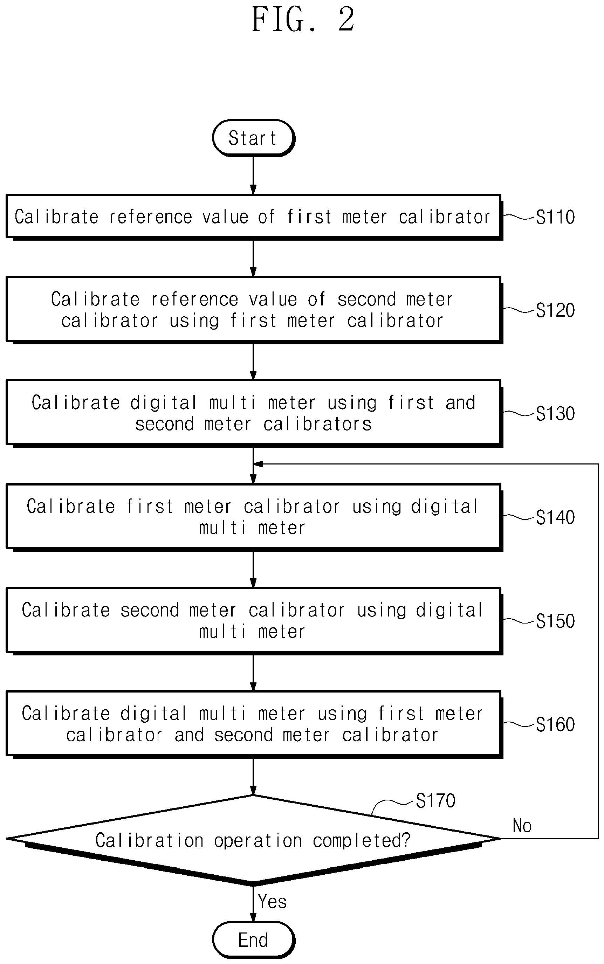

FIG. 2 is a diagram illustrating an upward range calibration according to the DC voltage function calibration device of FIG. 1.

Referring to FIG. 2, a reference value (10V), which is a DC voltage value, is calibrated with respect to one reference point of the first meter calibrator 110 through a higher standard device (not shown) (operation S110). Here, the reference value is set to 10V for convenience of explanation, but it may be set to a DC voltage value other than 10V.

The DC voltage calibration circuit 140 calibrates the reference point of the second meter calibrator 120 using the reference value of the first meter calibrator 110 (operation S120). The DC voltage calibration circuit 140 calibrates the -10V point of the second meter calibrator 120 with the reference value of 10V for the first meter calibrator 110. At this time, the DC voltage calibration circuit 140 may control through a switch so that the first plus terminal 111 of the first meter calibrator 110 is connected to the second minus terminal 122 of the second meter calibrator 120, and the first minus terminal 112 of the first meter calibrator 110 is connected to the first plus terminal 121 of the second meter calibrator 120. Through this, the plus terminals 111 and 121 and the minus terminals 112 and 122 of the first meter calibrator 110 and the second meter calibrator 120 are connected to each other.

The DC voltage calibration circuit 140 calibrates to a point that is twice the reference value of the digital multi meter 130 using the first meter calibrator 110 and the second meter calibrator 120 (operation S130). In the connection state as shown in FIG. 1, the DC voltage calibration circuit 140 may control the first meter calibrator 110 to output 10V and controls the second meter calibrator 120 to output at -0V, thereby it may set the value of the digital multi meter 130 to 20V. At this time, when a voltage of 10V is inputted through the third plus terminal 131 of the digital multi meter 130, and a voltage of -10V is inputted through the third minus terminal 132, since they are inputs through the third minus terminal 133 having a negative polarity, they may become 10V and the combined output may become 20V.

Here, operations S110 to S130 are referred to as a method of substitution. This is called the basic calibration of the first meter calibrator 110, the second meter calibrator 120, and the digital multi meter 130.

The DC voltage calibration circuit 140 calibrates the first meter calibrator 110 with a point that is twice a previously calibrated point, using the digital multi meter 130 (operation S140). The DC voltage calibration circuit 140 calibrates the 20V point of the first meter calibrator 110 by controlling the digital multi meter 130 to output at a calibrated 20V.

The DC voltage calibration circuit 140 calibrates the second meter calibrator 110 with a point that is twice the previously calibrated point, using the digital multi meter 130 (operation S150). The DC voltage calibration circuit 140 calibrates the 20V point of the first meter calibrator 110 by controlling the digital multi meter 130 to output at a calibrated -20V.

The DC voltage calibration circuit 140 calibrates the digital multi meter 130 using the first meter calibrator 110 and the second meter calibrator 120 (operation S160). At this time, when the DC voltage calibration circuit 140 controls the first meter calibrator 110 to output a calibration point of 20V and controls the second meter calibrator 120 to output a calibration point of -20V, it may calibrate the digital multi meter 130 with a 40V point that is twice the previously calibrated point. The DC voltage calibration circuit 140 determines whether the calibration operation is completed (operation S170). At this time, the DC voltage calibration circuit 140 ends when the calibration operation is completed.

However, if the calibration operation is not completed, the DC voltage calibration circuit 140 proceeds to operation S140. Thereafter, when the DC voltage calibration circuit 140 mutually calibrates the first meter calibrator 110, the second meter calibrator 120, and the digital multi meter 130 by alternating to double points, after the above calibrated 10V, 20V, and 40V points, it may continue to calibrate extended points in the order of 80V and160V. Because of this, through n-times iterations of a method for extending previously extended points by 2 times to new reference points, it is possible to perform a basic calibration on the first meter calibrator 110, the second meter calibrator 120, and the digital multi meter 130 at a point corresponding to $2^n$ times.

Unlike this, in operation S160, when the DC voltage calibration circuit 140 controls the first meter calibrator 110 to output 10V and controls the second meter calibrator 120 to output -20V, it may calibrate the 30V point of the digital multi meter 130. Thereafter, the DC voltage calibration circuit 140 sets the output of the digital multi meter 130 to 30V, thereby it calibrates a point of 30V of the first meter calibrator 110 and the second meter calibrator 120. When the first meter calibrator 110 is controlled to output 10V and the second meter calibrator 120 is controlled to output -30V, the 40V point of the digital multi meter 130 may be calibrated. An extension method in such a manner may calibrate points corresponding to $2^{n+1}$.

Through this, it is possible to extend at a k-times interval of the reference point and to calibrate points corresponding to kn+1 times of the reference point. Here, k and 1 have values of 0, 1, 2, ....

As an example of the above-described operation, the combination of the first meter calibrator 110 and the second meter calibrator 120 may be set in various ways according to each extension operation. The calibration point $P_n$ of n-times extensions may be configured to set one of the multiple obtained from the beginning to the immediately preceding extension operation to the first meter calibrator 110 and the second meter calibrator 120, and since the sum of the first meter calibrator 110 and the second meter calibrator 120 is determined by the digital multi meter 130, it may be expressed by the following Equation 1.

[Equation 1]

$$P_n = (a_n + b_n)P_0$$

Here, n is a natural number (1, 2, 3, ...). $a_n$ is a multiple of the first meter calibrator 110 and a positive integer less than or equal to $2^{n-1}$ and $b_n$ is a multiple of the second meter calibrator 120 and a positive integer less than or equal to $2^{n-1}$. Po is a reference point.

When an equation for the extended voltage value is expressed from Equation 1, a calibration value $V_n$ of a meter calibrator or the digital multi meter 130 for a calibration point $P_n$ may be expressed by the following Equation 2.

[Equation 2]

$$V_n = (a_n + b_n)(1 + \delta(a_n, b_n))V_0$$

Here, $\delta(a_n, b_n)$ is a relative correction value of a calibration value for $a_n + b_n$ combination and $V_0$ is a reference value of a reference point.

Since the measurement ranges of the first meter calibrator 110, the second meter calibrator 120, and the digital multi meter 130 are divided into decimal intervals such as 10V or less, 100V or less, and 1000V or less, the interval should be divided and calibrated to units of 10 times the reference voltage.

For example, when the DC voltage calibration circuit 140 calibrates 10V to the initial reference voltage, the first meter calibrator 110, the second meter calibrator 120, and the digital multi meter 130 calibrate 10V, 30V, 50V, 70V, 90V, and 100V to calibrate the range below 100V. Here, when the DC voltage calibration circuit 140 sets the calibrated 100V to the reference voltage, the first meter calibrator 110, the second meter calibrator 120, and the digital multi meter 130 calibrate 300V, 500V, 700V, 900V, and 1000V. In such a manner, for the next interval, by using the maximum point of the immediately preceding interval as the new reference point, the DC voltage calibration circuit 140 may repeat the operation of calibrating the first meter calibrator 110, the second meter calibrator 120, and the digital multi meter 130.

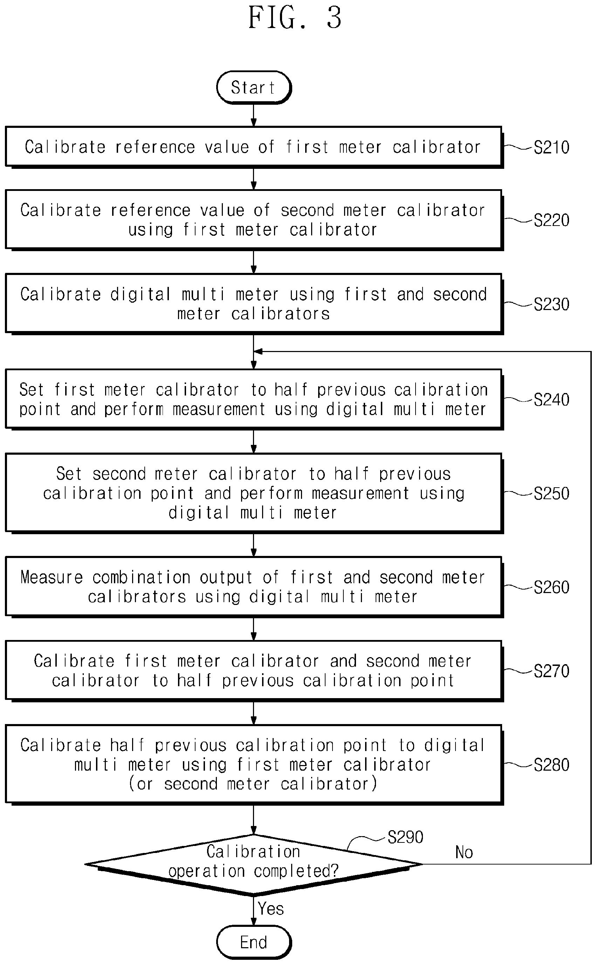

FIG. 3 is a flowchart illustrating an exemplary downward calibration operation of a DC voltage in a DC voltage calibration circuit according to an inventive concept.

Referring to FIG. 3, a reference value (10V), which is a DC voltage value, is calibrated with respect to one reference point of the first meter calibrator 110 through a higher standard device (not shown) (operation S210). Here, the reference value is set to 10V for convenience of explanation, but it may be set to a DC voltage value other than 10V.

The DC voltage calibration circuit 140 calibrates the reference point of the second meter calibrator 120 using the reference value of the first meter calibrator 110 (operation S220). The DC voltage calibration circuit 140 calibrates the -10V point of the second meter calibrator 120 with the reference value of 10V for the first meter calibrator 110. At this time, the DC voltage calibration circuit 140 may control through a switch so that the first plus terminal 111 of the first meter calibrator 110 is connected to the second minus terminal 122 of the second meter calibrator 120, and the first minus terminal 112 of the first meter calibrator 110 is connected to the first plus terminal 121 of the second meter calibrator 120. Through this, the plus terminals 111 and 121 and the minus terminals 112 and 122 of the first meter calibrator 110 and the second meter calibrator 120 are connected to each other.

The DC voltage calibration circuit 140 calibrates to a point that is twice the reference value of the digital multi meter 130 using the first meter calibrator 110 and the second meter calibrator 120 (operation S230). In the connection state as shown in FIG. 1, the DC voltage calibration circuit 140 controls the first meter calibrator 110 to output 10V and controls the second meter calibrator 120 to output -10V, so that it may set the value of the digital multi meter 130 to 20V. At this time, when a voltage of 10V is inputted through the third plus terminal 131 of the digital multi meter 130, and a voltage of -10 V is inputted through the third minus terminal 132, since they are inputs through the third minus terminal 132 having a negative polarity, they may become 10V and the combined output may become 20V.

The DC voltage calibration circuit 140 sets the first meter calibrator 110 to half of the previous calibration point and measures the set value using the digital multi meter 130 (operation S240). The DC voltage calibration circuit 140 sets the first meter calibrator 110 to 5V and controls to output the set value of 5V. Thereafter, the DC voltage calibration circuit 140 measures the output value V1 of the first meter calibrator 110 using the digital multi meter 130.

The DC voltage calibration circuit 140 sets the second meter calibrator 120 to half of the previous calibration point and measures the set value using the digital multi meter 130 (operation S250). The DC voltage calibration circuit 140 sets the second meter calibrator 120 to -5V and controls to output the set value of -5V. Thereafter, the DC voltage calibration circuit 140 measures the output value V1 of the second meter calibrator 120 using the digital multi meter 130.

The DC voltage calibration circuit 140 sets the input polarity of the digital multi meter 130 to read the bipolar indication value (+5V). Through this, the output values V1 and V2 may be obtained.

The DC voltage calibration circuit 140 connects the first meter calibrator 110 and the second meter calibrator 120 in series with each other in the opposite polarity and measures the same using the digital multi meter (S240) (operation S260). At this time, a value measured by the digital multi meter 130 is referred to as U3. For example, when the first meter calibrator 110 is set to 5V and the second meter calibrator 120 is set to -5V, the output values of the first meter calibrator 110 and the second meter calibrator 120 are defined as unknowns X1 and -X2, respectively. X1 and X2 are positive numbers and have a relation of $X1 \simeq X2$. When the values of X1 and X2 are added, U3(X1 + X2 = U3) is obtained. Generally, the difference between the values of the first and second meter calibrators 110 and 120 is very small, and the linearity of the digital multi meter 130 having a high resolution is excellent. This may be expressed by the following Equation 3.

[Equation 3]

$$X1 - X2 \simeq V1 - V2$$

Through this, X1 and X2 may be expressed by the following Equation 4.

[Equation 4]

$$X1 = (U3 + V1 - V2)/2$$

$$X2 = (U3 - V1 + V2)/2$$

Using Equation 4, the DC voltage calibration circuit 140 may obtain an output value of 5V of two meter calibrators.

The DC voltage calibration circuit 140 calibrates the first meter calibrator 110 and the second meter calibrator 120 to half of the previous calibration point using Equation 4 (operation S270). At this time, the DC voltage calibration circuit 140 calibrates a point of 5 V in the first meter calibrator 110 and a point of -5 V in the second meter calibrator 120.

The DC voltage calibration circuit 140 calibrates the digital multi meter 130 using the first meter calibrator 110 (or the second meter calibrator 120).

Through this, the DC voltage calibration circuit 140 calibrates the first meter calibrator 110, the second meter calibrator 120, and the digital multi meter 130 to 5V, which is half of the reference point.

The DC voltage calibration circuit 140 determines whether the calibration operation is completed (operation S290). The DC voltage calibration circuit 140 ends when the calibration operation is completed. However, if the calibration operation is not completed, the DC voltage calibration circuit 140 proceeds to operation S240 for downward calibration.

In such a way, if the above downward extension process is repeated n times using the point that is downward-extended in the previous operation as a new reference point, by extending the calibration point downward by half the previous calibration point, the first meter calibrator 110, the second meter calibrator 120, and the digital multi meter 130 may calibrate a point corresponding to $1/2^n$ of the reference point such as 5V, 2.5V, 1.25V, 0.625V, and 0.3125V.

On the other hand, if Equation 2 is set inversely, a point corresponding to dividing the reference point Po corresponding to the initial reference value $V_0$ for downward extension by an integer multiple is determined as a downward calibration point, and the downward calibration point is set to the reference point $P_{-n}$, and then, the value is defined as X. It selects the upward extension method to generate the scaling integer values of the reference points Po and $P_{-n}$, and determines the extension number n and the extension constants an and bn. An arbitrary predicted value is determined to be a virtual reference value by the X value (e.g., determine the correction value of the digital multi meter 130 as 0), and n-times extended calibration of Equation 2 is performed. At this time, the value Y extended from the virtual reference value X may be expressed by the following Equation 5.

[Equation 5]

$$Y = (a_n + b_n)(1 + \delta(a_n, b_n))V_0$$

If the virtual reference point value X is correct, the value of Y should be the original reference value $V_0$. That is, if the actual value of the desired downward calibration point $P_{-n}$ is defined as $v_n$, the following Equation 6 is established.

[Equation 6]

$$V_0 = (a_n + b_n)(1 + \delta(a_n b_n))v_n$$

If there is a difference between Y and Vo, the difference value may be obtained. If the relative difference is determined as d, the following Equation 7 is established.

[Equation 7]

$$Y = V_0(1+d)$$

Through this, Equation 8 below may be obtained.

[Equation 8]

$$V_0(1+d) = (a_n + b_n)(1 + \delta(a_n, b_n))X$$

When assuming that the actual value of the downward calibration point $P_{-n}$ to be calibrated is $v_n$, the following Equation 9 may be obtained.

[Equation 9]

$$v_n = V_0/(a_n + b_n)(1 + \delta(a_n, b_n)) = X/(1+d)$$

In such a way, a virtual reference point is set, and the result value obtained by performing the upward calibration from the virtual reference point is compared with the previously calibrated value so that the downward conversion may be performed through correction of the virtual reference point value. For example, the initial reference point of 10V may be extended downward to 1V, and when a calibration value of 1V point is obtained, for 3V, 5V, 7V, and 9V points, calibration may be performed by applying the upward extension of FIG. 2. Alternatively, various downward point calibrations may be performed in combination with a low point calibration scheme corresponding to $1/2^n$. For example, as a first downward extension method, it may be downward-extended to 5V with an initial reference point of 10V, and then the virtual 1V reference value is upwardextended to 5V (1V -> 2V -> 3V -> 5V) to obtain the final operation d. Then, the calibration value of a 1V point may be obtained by using Equation 6. Then, the calibration values of 2V and 3V may also be calculated using the values obtained in the immediately-preceding performed virtual upward-extension process. Calibrations of 4V, 6V, 7V, 8V, and 9V are possible through upward extension with the combination of 1V, 2V, 3V, and 5V.

In the inventive concept, since the multifunction meter (or meter calibrator) may perform its own calibration based on one reference point for each function, a wide range of standard retroactive property may be obtained efficiently with low cost and time. The calibration described in the inventive concept means that the indication value of the corresponding measurement instrument forms a relationship loop to be retroactive to the upper standard. In the inventive concept, calibration refers to the formation of the standard retroactive relationship, not to the adjustment of the corresponding instrumentation, if necessary, and refers to the operation of obtaining the difference between the indication value and the standard value.

Through this, in the inventive concept, although the high-resolution digital multi meter 130 has lower stability performance than the meter calibrator, there is no performance problem in measuring the first and second meter calibrators 110 and 120 for a short period of time. Therefore, the high resolution of the digital multi meter 130 is utilized only as an intermediary role. For this, the second meter calibrator 120 and the digital multi meter 130 are also calibrated together with the first meter calibrator 110.

Although the exemplary embodiments of the inventive concept have been described, it is understood that the inventive concept should not be limited to these exemplary embodiments but various changes and modifications can be made by one ordinary skilled in the art within the scope of the inventive concept as hereinafter claimed.

**INDUSTRIAL APPLICABILITY**

The inventive concept relates to a measurement device, and a DC voltage function calibration device and method of a multifunction meter calibrator that enables calibration of various points for DC voltage may be provided.

**Claims**

1. A DC voltage function calibration device comprising:

a first meter calibrator (110) configured to be calibrated to a reference value for a reference point and having a first plus terminal (111) and a first minus terminal (112);
a second meter calibrator (120) configured to be calibrated to the reference value for the reference point and having a second plus terminal (121) and a second minus terminal (122) connected to the first minus terminal (112);
a digital multi meter (130) having a third plus terminal (131) connected to the first plus terminal (111) and a third minus terminal (132) connected to the second plus terminal (121); and
a DC voltage calibration circuit (140) configured to control the calibration of a DC voltage for other points through up-converting or down-converting a voltage value based on the reference value set in the first meter calibrator (110) and the second meter calibrator (120), wherein the DC voltage calibration circuit (140) is configured to calibrate an extension point of the digital multi meter (130) using the combined voltage of the first meter calibrator (110) and the second meter calibrator (120) as a reference of the extension point.

**2.** The DC voltage function calibration device of claim 1, wherein when the DC voltage calibration circuit (140) is calibrated with a reference value as a reference value through a higher standard device for one of the first meter calibrator (110) and the second meter calibrator (120), the first plus terminal (111) is connected to the second minus terminal and the second minus terminal is connected to the first plus terminal (111) to calibrate a voltage of a minus polarity to another meter calibrator.

**3.** The DC voltage function calibration device of claim 2, wherein the DC voltage calibration circuit (140) upward-extends the plus polarity point of the third plus terminal (131) and the minus polarity point of the third minus terminal (132) of the digital multi meter (130) through calibration with a combination voltage as a reference of an extension point with respect to a voltage calibrated to the first meter calibrator (110) and the second meter calibrator (120).

**4.** The DC voltage function calibration device of claim 3, wherein the DC voltage calibration circuit (140) calibrates points corresponding to $2^n$ times or $2^{n+1}$ times with respect to the reference value through n-times iterations of an operation according to a upward extension.

**5.** The DC voltage function calibration device of claim 4, wherein the DC voltage calibration circuit (140) determines as a virtual reference point a low point corresponding to dividing a minimum point by an integer multiple among the points calibrated to the first meter calibrator (110) and the second meter calibrator (120), compares the value obtained through the upward extension with the reference value of the minimum point to obtain a state deviation, and calibrates a virtual reference value assigned to the virtual reference point by the state deviation to calibrate the virtual reference point.

**6.** The DC voltage function calibration device of claim 2, wherein the DC voltage calibration circuit (140) measures the combination voltage of the first meter calibrator (110) and the second meter calibrator (120) using the digital multi meter (130), and downward-extends a point corresponding to half the minimum point through calibration after measuring a difference voltage between the first meter calibrator (110) and the second meter calibrator (120), through a calculation of the output value of the first meter calibrator (110) and the second meter calibrator (120) from the combination voltage and the difference voltage.

**7.** The DC voltage function calibration device of claim 6, wherein the DC voltage calibration circuit (140) calibrates points corresponding to $1/2^n$ times with respect to the reference value through n-times iterations of an operation according to the downward expansion.

**8.** A DC voltage function calibration method comprising:

calibrating a reference point as a reference value through a higher standard device for one of a first meter calibrator (110) and a second meter calibrator (120); connecting a first plus terminal (111) of a first meter calibrator (110) to a second minus terminal of the second meter calibrator (120) and connecting a second plus terminal (121) of the second meter calibrator (120) to a first minus terminal (112) of the first meter calibrator (110) to calibrate a voltage of a minus polarity to another meter calibrator; connecting the first plus terminal (111) to a third plus terminal (131) of a digital multi meter (130), connecting the second plus terminal (121) to a third minus terminal (132) of the digital multi meter (130), and connecting the first minus terminal (112) to the second minus terminal (122); calibrating a plus polarity point and a minus polarity point of a digital multi meter (130) based on a combination point as a reference of an extension point with respect to a voltage calibrated to the first meter calibrator (110) and the second meter calibrator (120); and calibrating a DC voltage for other points through up-converting or down-converting a voltage value based on the reference value set in the first meter calibrator (110) and the second meter calibrator (120), wherein an extension point of the digital multi meter (130) is calibrated using the combined voltage of the first meter calibrator (110) and the second meter calibrator (120) as a reference of the extension point.

**9.** The DC voltage function calibration method of claim 8, wherein the controlling to calibrate the DC voltage for the other points through the up-converting comprises upward-extending the plus polarity point of the third plus terminal (131) and the minus polarity point of the third minus terminal (132) of the digital multi meter (130) based on a combination voltage as an extension point through an iteration of a calibration operation with respect to the voltage calibrated to the first meter calibrator (110) and the second meter calibrator (120).

**10.** The DC voltage function calibration method of claim 9, wherein the controlling to calibrate the DC voltage for the other points through the up-converting comprises:

determining as a virtual reference point a low point corresponding to dividing a minimum point by an integer multiple among the points calibrated to the first meter calibrator (110) and the second meter calibrator (120);

comparing the value obtained through the upward extension with the reference value of the minimum point to obtain a state deviation; and

calibrating a virtual reference value assigned to the virtual reference point by the state deviation to calibrate the virtual reference point.

11. The DC voltage function calibration method of claim 8, wherein the controlling to calibrate the DC voltage for the other points through the down-converting comprises:

measuring the combination voltage of the first meter calibrator (110) and the second meter calibrator (120) using the digital multi meter (130);

measuring a difference voltage between the first meter calibrator (110) and the second meter calibrator (120); and

downward-extending a point corresponding to half the minimum point through calibration through a calculation of the output value of the first meter calibrator (110) and the second meter calibrator (120) from the combination voltage and the difference voltage.

**Patentansprüche**

1. Gleichspannungsfunktions-Kalibrierungsvorrichtung, aufweisend:

einen ersten Messgerätkalibrator (110), der konfiguriert ist, auf einen Bezugswert für einen Bezugspunkt kalibriert zu werden, und einen ersten Pluspol (111) und einen ersten Minuspol (112) aufweist;

einen zweiten Messgerätkalibrator (120), der konfiguriert ist, auf den Bezugswert für den Bezugspunkt kalibriert zu werden, und einen zweiten Pluspol (121) und einen zweiten Minuspol (122), der mit dem ersten Minuspol (112) verbunden ist, aufweist;

ein digitales Mehrfachmessgerät (130) mit einem dritten Pluspol (131), der mit dem ersten Pluspol (111) verbunden ist, und einem dritten Minuspol (132), der mit dem zweiten Minuspol (121) verbunden ist; und

eine Gleichspannungs-Kalibrierungsschaltung (140), die konfiguriert ist, die Kalibrierung einer Gleichspannung für andere Punkte durch Aufwärtswandeln oder Abwärtswandeln eines Spannungswerts basierend auf dem im ersten Messgerätkalibrator (110) und im zweiten Messgerätkalibrator (120) eingestellten Bezugswert zu steuern, wobei die Gleichspannungs-Kalibrierungsschaltung (140) konfiguriert ist, einen Erweiterungspunkt des digitalen Mehrfachmessgeräts (130) unter Verwendung der kombinierten Spannung des ersten Messgerätkalibrators (110) und des zweiten Messgerätkalibrators (120) als einen Bezug des Erweiterungspunkts zu kalibrieren.

2. Gleichspannungsfunktions-Kalibrierungsvorrichtung nach Anspruch 1, wobei, wenn die Gleichspannungs-Kalibrierungsschaltung (140) mit einem Bezugswert als ein Bezugswert durch eine Vorrichtung mit erhöhtem Standard für einen des ersten Messgerätkalibrators (110) und des zweiten Messgerätkalibrators (120) kalibriert wird, der erste Pluspol (111) mit dem zweiten Minuspol verbunden ist und der zweite Minuspol ist mit dem ersten Pluspol (111) verbunden ist, um eine Spannung einer Minuspolarität auf einen weiteren Messgerätkalibrator zu kalibrieren.

3. Gleichspannungsfunktions-Kalibrierungsvorrichtung nach Anspruch 2, wobei die Gleichspannungs-Kalibrierungsschaltung (140) den Pluspolaritätspunkt des dritten Pluspols (131) und den Minuspolaritätspunkt des dritten Minuspols (132) des digitalen Mehrfachmessgeräts (130) durch Kalibrieren mit einer Kombinationsspannung als einen Bezug eines Erweiterungspunkts in Bezug auf eine auf den ersten Messgerätkalibrator (110) und auf den zweiten Messgerätkalibrator (120) kalibrierte Spannung nach oben erweitert.

4. Gleichspannungsfunktions-Kalibrierungsvorrichtung nach Anspruch 3, wobei die Gleichspannungs-Kalibrierungsschaltung (140) Punkte, die $2^n$ Mal oder $2^{n+1}$ Mal in Bezug auf den Bezugswert entsprechen, durch n-malige Wiederholungen einer Operation gemäß einer Aufwärtserweiterung kalibriert.

5. Gleichspannungsfunktions-Kalibrierungsvorrichtung nach Anspruch 4, wobei die Gleichspannungs-Kalibrierungsschaltung (140) einen niedrigen Punkt, der einem Teilen eines Mindestpunkts durch ein ganzzahliges Vielfaches entspricht, unter den auf den ersten Messgerätkalibrator (110) und auf den zweiten Messgerätkalibrator (120) kalibrierten Punkten als einen virtuellen Bezugspunkt bestimmt, den durch die Aufwärtserweiterung erhaltenen Wert mit dem Bezugswert des Mindestpunkts zum Erhalten einer Zustandsabweichung vergleicht, und einen virtuellen Bezugswert kalibriert, der dem virtuellen Bezugspunkt durch die Zustandsabweichung zugewiesen wird, um den virtuellen Bezugspunkt zu kalibrieren.

6.  Gleichspannungsfunktions-Kalibrierungsvorrichtung nach Anspruch 2, wobei die Gleichspannungs-Kalibrierungsschaltung (140) die Kombinationsspannung des ersten Messgerätkalibrators (110) und des zweiten Messgerätkalibrators (120) unter Verwendung des digitalen Mehrfachmessgeräts (130) misst und einen Punkt, welcher der Hälfte des Mindestpunkts entspricht, durch Kalibrieren, nachdem eine Differenzspannung zwischen dem ersten Messgerätkalibrator (110) und dem zweiten Messgerätkalibrator (120) gemessen worden ist, durch eine Berechnung des Ausgabewerts des ersten Messgerätkalibrators (110) und des zweiten Messgerätkalibrators (120) aus der Kombinationsspannung und der Differenzspannung nach unten erweitert.

7.  Gleichspannungsfunktions-Kalibrierungsvorrichtung nach Anspruch 6, wobei die Gleichspannungs-Kalibrierungsschaltung (140) Punkte, die 1/2" Mal in Bezug auf den Bezugswert entsprechen, durch n-malige Wiederholungen einer Operation gemäß der Abwärtserweiterung kalibriert.

8.  Gleichspannungsfunktions-Kalibrierungsverfahren, aufweisend:

    Kalibrieren eines Bezugspunkts als einen Bezugswert durch eine Vorrichtung mit erhöhtem Standard für einen ersten Messgerätkalibrator (110) und einen zweiten Messgerätkalibrator (120);
    Verbinden eines ersten Pluspols (111) eines ersten Messgerätkalibrators (110) mit einem zweiten Minuspol des zweiten Messgerätkalibrators (120) und Verbinden eines zweiten Pluspols (121) des zweiten Messgerätkalibrators (120) mit einem ersten Minuspol (112) des ersten Messgerätkalibrators (110) zum Kalibrieren einer Spannung einer Minuspolarität auf einen weiteren Messgerätkalibrator;
    Verbinden eines ersten Pluspols (111) mit einem dritten Pluspol (131) eines digitalen Mehrfachmessgeräts (130), Verbinden des zweiten Pluspols (121) mit einem dritten Minuspol (132) des digitalen Mehrfachmessgeräts (130), und Verbinden des ersten Minuspols (112) mit dem zweiten Minuspol (122);
    Kalibrieren eines Pluspolaritätspunkts und eines Minuspolaritätspunkts eines digitalen Mehrfachmessgeräts (130) basierend auf einem Kombinationspunkt als ein Bezug eines Erweiterungspunkts in Bezug auf eine auf den ersten Messgerätkalibrator (110) und auf den zweiten Messgerätkalibrator (120) kalibrierte Spannung; und
    Kalibrieren einer Gleichspannung für andere Punkte durch Aufwärtswandeln oder Abwärtswandeln eines Spannungswerts basierend auf dem im ersten Messgerätkalibrator (110) und im zweiten Messgerätkalibrator (120) eingestellten Bezugswert, wobei ein Erweiterungspunkt des digitalen Mehrfachmessgeräts (130) unter Verwendung der kombinierten Spannung des ersten Messgerätkalibrators (110) und des zweiten Messgerätkalibrators (120) als ein Bezug des Erweiterungspunkts kalibriert wird.

9.  Gleichspannungsfunktions-Kalibrierungsverfahren nach Anspruch 8, wobei das Steuern zum Kalibrieren der Gleichspannung für die anderen Punkte durch Aufwärtswandeln aufweist, dass der Pluspolaritätspunkt des dritten Pluspols (131) und der Minuspolaritätspunkt des dritten Minuspols (132) des digitalen Mehrfachmessgeräts (130) basierend auf einer Kombinationsspannung als ein Erweiterungspunkt durch eine Wiederholung einer Kalibrierungsoperation in Bezug auf die auf den ersten Messgerätkalibrator (110) und auf den zweiten Messgerätkalibrator (120) kalibrierte Spannung nach oben erweitert werden.

10. Gleichspannungsfunktions-Kalibrierungsverfahren nach Anspruch 9, wobei das Steuern zum Kalibrieren der Gleichspannung für die anderen Punkte durch das Aufwärtswandeln aufweist:

    Bestimmen eines niedrigen Punkts, der einem Teilen eines Mindestpunkts durch ein ganzzahliges Vielfaches entspricht, unter den auf den ersten Messgerätkalibrator (110) und auf den zweiten Messgerätkalibrator (120) kalibrierten Punkten als einen virtuellen Bezugspunkt;
    Vergleichen des durch die Aufwärtserweiterung erhaltenen Werts mit dem Bezugswert des Mindestpunkts zum Erhalten einer Zustandsabweichung; und
    Kalibrieren eines dem virtuellen Bezugspunkt zugewiesenen virtuellen Bezugswerts durch die Zustandsabweichung, um den virtuellen Bezugspunkt zu kalibrieren.

11. Gleichspannungsfunktions-Kalibrierungsverfahren nach Anspruch 8, wobei das Steuern zum Kalibrieren der Gleichspannung für die anderen Punkte durch das Abwärtswandeln aufweist:

    Messen der Kombinationsspannung des ersten Messgerätkalibrators (110) und des zweiten Messgerätkalibrators (120) unter Verwendung des digitalen Mehrfachmessgeräts (130);
    Messen einer Differenzspannung zwischen dem ersten Messgerätkalibrator (110) und dem zweiten Messgerätkalibrator (120); und
    Abwärtserweitem eines Punkts, welcher der Hälfte des Mindestpunkts entspricht, durch Kalibrieren durch eine Berechnung des Ausgabewerts des ersten Messgerätkalibrators (110) und des zweiten Messgerätkalibrators (120) aus der Kombinationsspannung und der Differenzspannung.

## Revendications

1. Dispositif d'étalonnage de fonction de tension continue comprenant :

    - un premier calibreur métrique (110) configuré pour être étalonné à une valeur de référence pour un point de référence et ayant un première borne plus (111) et une première borne moins (112),
    - un second calibreur métrique (120) configuré pour être étalonné à la valeur de référence pour le point de référence et avoir un second terminal plus (121) et un second terminal moins (122) connectée à la première borne moins (112),
    - un multimètre numérique (130) ayant une troisième borne plus (131) connectée à la première borne plus (111) et une troisième borne moins (132) connectée à la seconde borne plus (121), et
    - un circuit (140) d'étalonnage de tension continue configuré pour contrôler l'étalonnage d'une tension continue pour d'autres points par une conversion ascendante ou descendante d'une valeur de tension basée sur la valeur de référence fixée dans le premier calibreur métrique (110) et le second calibreur métrique (120) dans le circuit d'étalonnage de courant continu (140) étant configuré pour calibrer un point d'extension du multimètre numérique (130) utilisant la tension continue du premier calibreur métrique (110) et du second calibreur métrique (120) en tant que référence du point d'extension.

2. Dispositif d'étalonnage de fonction de tension continue selon la revendication 1, dans lequel

    - lorsque le circuit d'étalonnage (140) est étalonné avec une valeur de référence en tant que valeur de référence par un dispositif de standard plus élevé pour le premier calibreur métrique (110) ou le second calibreur métrique (120), la première borne plus (111) est connecté à la seconde borne moins et la seconde borne moins est connectée à la seconde borne plus (111) pour calibrer une tension de polarité négative vers un autre calibreur métrique.

3. Dispositif d'étalonnage de fonction de tension de tension selon la revendication 2,

dans lequel
le circuit d'étalonnage de tension continue (140) développe vers le haut
le point de polarité plus de la troisième borne plus (131), et
le point de polarité moins de la troisième borne moins (132) du multimètre numérique (130) par un étalonnage avec une tension combinée en tant que référence d'un point d'extension par rapport à une tension étalonnée vers le premier calibreur métrique (110) et le second calibreur métrique (120).

4. Dispositif d'étalonnage de fonction de tension de tension selon la revendication 3,
dans lequel
le circuit d'étalonnage de tension continue (140) étalonne des points correspondant à $2^n$ fois ou $2^{n-1}$ fois en respectant la valeur de référence par n itérations d'une opération selon une extension ascendante.

5. Dispositif d'étalonnage de fonction de tension continue selon la revendication 4,

    dans lequel
    le circuit d'étalonnage de tension continue (140) détermine en tant que point de référence virtuelle, un point bas correspondant en divisant un point minimum par un multiple entier choisi parmi les points étalonnés pour le premier calibreur métrique (110) et le second calibreur métrique (120),
    compare la valeur obtenue par le développement ascendant avec la valeur de référence du point minimum pour obtenir une déviation d'état, et étalonne une valeur de référence virtuelle assignée au point de référence virtuelle par la déviation d'état pour étalonner le point de référence virtuelle.

6. Dispositif d'étalonnage de fonction de tension de tension selon la revendication 2,

    dans lequel
    le circuit d'étalonnage de tension continue (140) mesure la tension combinée du premier calibreur métrique (110) et le second calibreur métrique (120) en utilisant le multimètre numérique (130),
    et étend vers le bas un point correspondant à la moitié du point minimum par l'étalonnage après avoir mesuré une différence de tension entre le premier calibreur métrique (110) et le second calibreur métrique (120) par un calcul de la valeur de sortie du premier calibreur métrique (110) et le second calibreur métrique (120) de la tension combinée et la différence de tension.

**7.** Dispositif d'étalonnage de fonction de tension de tension selon la revendication 6,
dans lequel
le circuit d'étalonnage de tension de courant continu (140) étalonne des points correspondants à $1/2^n$ fois la valeur de référence par n itérations d'une opération en fonction de l'extension vers le bas.

**8.** Procédé d'étalonnage de fonction de tension de tension continue consistant à :

- étalonner un point de référence comme valeur de référence par un appareil de standard plus élevé pour le premier calibreur métrique (110) ou le second calibreur métrique (120),
- connecter une première borne plus (111) d'un premier calibreur métrique (110) à une seconde borne moins du second calibreur métrique (120), et
- connecter une seconde borne plus (121) du second calibreur métrique (120) à une première borne moins (112) du premier calibreur métrique (110) pour étalonner la tension d'une polarité négative pour un autre calibreur métrique,
- connecter la première borne plus (111) à une troisième borne plus (131) d'un multimètre numérique (130), connecter la seconde borne plus (121) à une troisième borne moins (132) du multimètre numérique (130) et connecter la première borne moins (112) à la seconde borne moins (122),
- étalonner un point de polarité positive et un point de polarité négative d'un multimètre numérique (130) basé sur un point de combinaison en tant que référence d'un point par une tension étalonnée au premier calibreur métrique (110) et le second calibreur métrique (120), et
- étalonner une tension continue pour d'autres points par conversion ascendante ou descendante d'une valeur de tension basée sur la valeur de référence entrée dans le premier calibreur métrique -(110) et le second calibreur métrique (120), dans lequel un point d'extension d'un multimètre numérique (130) est étalonné en utilisant la tension combinée du premier calibreur métrique (110) et le second calibreur métrique (120) en tant que référence du point d'extension.

**9.** Procédé d'étalonnage de fonction de tension de tension continue selon la revendication 8,
dans lequel

- le contrôle pour étalonner la tension continue pour les autres points par la conversion ascendante comprend l'extension ascendante du point de polarité positive de la troisième borne plus (131) et le point de polarité négative de la troisième borne négative (132) du multimètre numérique (130) basé sur une tension de combinaison en tant que point d'extension par une itération d'une opération détalonnage par rapport à la tension étalonnée du premier calibreur métrique (110) et le second calibreur métrique (120).

**10.** Procédé d'étalonnage de fonction de tension de tension continue selon la revendication 9,
dans lequel
le contrôle pour étalonner la tension continue pour les autres points par la conversion ascendante consistant à :

- déterminer comme point de référence virtuelle, un point bas correspondant à la division d'un point minimum par un multiple entier choisi parmi les points étalonnés par le premier calibreur métrique (110) et le second calibreur métrique (120),
- comparer la valeur obtenue par l'extension ascendante avec la valeur de référence du point minimum pour obtenir une déviation d'état, et
- étalonner une valeur de référence virtuelle assigné au point de référence virtuelle par la déviation d'état pour étalonner le point de référence virtuel.

**11.** Procédé d'étalonnage de fonction de tension de tension continue selon la revendication 8,
dans lequel
le contrôle pour étalonner la tension continue pour les autres points à travers la conversion descendante consiste à :

- mesurer de la tension de combinée du premier calibreur métrique (110) et du second calibreur métrique (120) avec le multimètre numérique (130)
- mesurer la différence de tension entre le premier calibreur métrique (110) et le second calibreur métrique (120), et
- extension descendante d'un point correspondant à la moitié du point minimum par l'étalonnage un calcul de la valeur de sortie du premier calibreur métrique (110) et du second calibreur métrique (120) à partir de la tension de combinée et la différence de tension.

# FIG. 1

# FIG. 2

```
                        ┌─────────┐
                        │  Start  │
                        └────┬────┘
                             │
                             ▼
     ┌─────────────────────────────────────────────────┐
     │ Calibrate reference value of first meter calibrator │──S110
     └─────────────────────────┬───────────────────────┘
                               │
                               ▼
     ┌─────────────────────────────────────────────────┐
     │ Calibrate reference value of second meter         │──S120
     │ calibrator using first meter calibrator           │
     └─────────────────────────┬───────────────────────┘
                               │
                               ▼
     ┌─────────────────────────────────────────────────┐
     │ Calibrate digital multi meter using first and     │──S130
     │ second meter calibrators                          │
     └─────────────────────────┬───────────────────────┘
                               │
                               ▼
     ┌─────────────────────────────────────────────────┐
     │ Calibrate first meter calibrator using digital    │──S140
     │ multi meter                                       │
     └─────────────────────────┬───────────────────────┘
                               │
                               ▼
     ┌─────────────────────────────────────────────────┐
     │ Calibrate second meter calibrator using digital   │──S150
     │ multi meter                                       │
     └─────────────────────────┬───────────────────────┘
                               │
                               ▼
     ┌─────────────────────────────────────────────────┐
     │ Calibrate digital multi meter using first meter   │──S160
     │ calibrator and second meter calibrator            │
     └─────────────────────────┬───────────────────────┘
                               │
                               ▼                       S170
                        ◇─────────────────◇
                        Calibration operation completed?  ──No──┐
                        ◇─────────────────◇
                               │Yes
                               ▼
                        ┌─────────┐
                        │   End   │
                        └─────────┘
```

# FIG. 3

Start

Calibrate reference value of first meter calibrator — S210

Calibrate reference value of second meter calibrator using first meter calibrator — S220

Calibrate digital multi meter using first and second meter calibrators — S230

Set first meter calibrator to half previous calibration point and perform measurement using digital multi meter — S240

Set second meter calibrator to half previous calibration point and perform measurement using digital multi meter — S250

Measure combination output of first and second meter calibrators using digital multi meter — S260

Calibrate first meter calibrator and second meter calibrator to half previous calibration point — S270

Calibrate half previous calibration point to digital multi meter using first meter calibrator (or second meter calibrator) — S280

Calibration operation completed? — S290   No

Yes

End

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Comparison of the Reference Step Method with a MI 8000/8001 Potentiometer. **MARTIN SIRA et al.** PRECISION ELECTROMAGNETIC MEASUREMENTS 2012 CONFERENCE ON. IEEE, 01 July 2012, 540-541